# EUROPEAN PATENT APPLICATION

(11) **EP 4 611 494 A1**
(43) Date of publication of application: **03.09.2025**
(21) Application number: 24160243.2
(22) Date of filing: 28.02.2024
(51) Int. Cl.: H05K 5/00, H05K 7/20

(54) **SUPPORT ELEMENT FOR AN ELECTRICAL VEHICLE COMPONENT**

(71) Applicant: VOLVO CAR CORPORATION, 405 31 Göteborg (SE)
(72) Inventor: ANDERSSON, Johan, 40531 Göteborg (SE); PHILLIPS, Adam, 40531 Göteborg (SE)
(74) Representative: Maiwald GmbH

(57) **Abstract**

A support element (1) for supporting an electrical vehicle component (100) inside a vehicle (200), wherein the support element (1) comprises a plate-shaped body (3) extending essentially along a height direction (50) in an operational orientation of the vehicle (200), wherein the plate-shaped body (3) comprises at least one connecting portion (5) for connecting at least one electrical vehicle component (100) to the support element (1), and wherein the support element (1) comprises at least one fluid flow channel (7) for guiding at least one heat transporting fluid.

## Description

### TECHNICAL FIELD

The present disclosure relates to a support element for supporting an electrical vehicle component inside a vehicle.

The present disclosure further relates to a vehicle body for a vehicle comprising such a support element.

The present disclosure further relates to a vehicle comprising such a support element.

The present disclosure also relates to a use of a support element.

### BACKGROUND ART

Nowadays, electrical vehicle components, such as a vehicle core computer, have grown in size and importance in the vehicle. However, in the tightly packed vehicle, space constraints highly limit potential locations, at which the electrical vehicle components could be placed. In present solutions, electrical vehicle components are often placed in hidden locations of the vehicle which additionally are difficult to access. Thus, maintenance or exchange of such electrical vehicle components is not possible or could only be achieved with great difficulty and by employing complex mounting arrangements. It is noted that the electrical vehicle component may be formed by an electronic vehicle component.

### SUMMARY

It is therefore an objective of the present disclosure to provide an improved support element for supporting an electrical vehicle component, which may allow a simple and robust solution for mounting.

The problem is at least partially solved or alleviated by the subject matter of the independent claims of the present disclosure, wherein further preferred examples are incorporated in the dependent claims.

### SE:DJS

According to a first aspect, there is provided a support element for supporting an electrical vehicle component inside a vehicle.

The support element comprises a plate-shaped body extending essentially along a height direction in an operational orientation of the vehicle.

The plate-shaped body comprises at least one connecting portion for connecting at least one electrical vehicle component to the support element.

Further, the support element comprises at least one fluid flow channel for guiding at least one heat transporting fluid.

Thus, a support element may be provided, which may advantageously offer an increased mounting and support space for electrical vehicle components and at the same time provides a proper cooling of the electrical vehicle components without the need of additional elements. Hence, an implementation of such electrical vehicle components inside the vehicle may be facilitated by granting easy access, e.g. for maintenance, updating, service and repair of such electrical vehicle components. The plate-shaped appearance of the support element may create a compact mounting arrangement, which may be locatable in very constraint spaces of a vehicle, for instance at least partially between neighboring front passenger seats or rear passenger seats, and/or at least partially between the footwells of the front seats.

One or more electrical vehicle components may be supported by the support element. An electrical vehicle component may include any electrically operated element, such as in particular data processing or computing devices including one or more processors, data storage and/or memory elements, one or more devices for data transmission, but also non-data computing devices such as multimedia devices and/or electrical or electronic vehicle controls etc. Thus, as has already been mentioned before, the electrical vehicle component may be formed by an electronic vehicle component.

A direct connection between the electrical vehicle component and the support element or an indirect connection, e.g. by further means arranged for instance in between the electrical vehicle component and the support element may be provided. The electrical vehicle component may be sufficiently secured at the support element to allow operation of the electrical vehicle components during operation of the vehicle.

The plate-shaped body may extend essentially in a plate-shaped manner. That is, it may substantially extend in two main spatial extension directions, which may include a first extension direction and a second extension direction perpendicular to the first direction. At the same time, the plate -shaped body may only have a minor extension in a third extension direction perpendicular to the first and second extension directions. For instance, the plate-shaped body may extend essentially in a height direction and a length direction of an associated vehicle, while having only a small thickness perpendicular to the height and length direction.

The operational orientation may include a direction of a vehicle in a standard forward driving direction. A height direction in an operational orientation may be for instance a vertical direction perpendicular to the ground on which the vehicle moves. In this respect, the height direction is not to be construed to the vertical direction only but may also be inclined to the vertical direction, for instance if the vehicle operates or drives on a slope or is inclined.

One or more connecting portions may be provided at the plate-shaped body. The connecting portion may generally include the portion of the support element at which an electrical vehicle component may be mounted. In one example, the connecting portion may be substantially two-dimensional such that it may exhibit a flat, surface-like appearance. The electrical vehicle component may comprise a corresponding substantially two-dimensional contacting surface for contacting the connecting portion. The electrical vehicle component may be secured to the connection portion by one or more fastening elements, such as screws, clamps, etc. or may comprise protrusions or recesses which may engage respective corresponding protrusions or recesses of the connecting portion. The electrical vehicle component may be mounted in a permanent manner or may be detachably mounted to the support element.

One or more fluid flow channels may be provided at or in the support element. A fluid flow channel may be understood as a continuous hollow space which may be adapted to receive and guide respective heat transporting fluid. In this respect, the fluid flow channel may also be referred to as "cooling channel". In some examples, the fluid flow channel may comprise an inlet for receiving low temperature heat transporting fluid to an area where the electrical vehicle component is mounted. In some examples, the fluid flow channel may likewise comprise an outlet for withdrawing high temperature heat transporting fluid, which was heated by the electrical vehicle component, from said component. The fluid flow channel may comprise any suitable shape, such as a rectangular or oval or circular cross-sectional shape and may run in one or more straight lines or turns inside and along the support element to cover at least a partial area of the connecting portion. Generally, the fluid flow channel may be suitably dimensioned to allow a heat transporting fluid to be fed through it and maybe accordingly adapted to the heat transporting fluid employed, and or the heat transporting capacities needed to cool a corresponding electrical vehicle component mounted to the support element.

The heat transporting fluid may include one or more of a gas or liquid that is generally employable for heat absorption, transport and dissipation. Non-limiting examples may include water, Mono-ethylene glycol, Propylene glycol and/or synthetic oils and corresponding mixtures thereof.

Providing at least one fluid flow channel for guiding at least one heat transporting fluid has the advantage that an electrical vehicle component connected to the support element may be reliably cooled. Consequently, the electrical vehicle component may be operated in a reliable manner. Moreover, since the cooling may be realized via the fluid flow channel, other means of cooling the electrical vehicle component may be eliminated or reduced in size. In an example, a volume of ambient air that needs to be provided adjacent to the electrical vehicle component for dissipating heat may be reduced in size or eliminated. This is advantageous from a packaging point of view, i.e. this allows to install the electrical vehicle component in a restraint space and/or in a space-saving manner. Furthermore, due to the provision of the at least one fluid flow channel and the cooling realized therewith, highly performant electrical vehicle components may be used. This is due to the fact that highly performant electrical vehicle components often generate comparatively high amounts of heat that needs to be withdrawn in order to reliably operate the electrical vehicle component. In this context, a highly performant electrical vehicle component may be formed by an electrical vehicle component that is highly compact. These circumstances additionally facilitate an installation of the electrical vehicle component in a restraint space and/or in a space-saving manner.

In one example, the fluid flow channel is thermally coupled to the connecting portion.

Thus, an improved thermal transfer between the electrical vehicle component mounted to the connecting portion and the heat transporting fluid guided through the fluid flow channel may be achieved. Accordingly, an electrical vehicle component connected to the connection portion and supported by the support element may be cooled in a simple and reliable manner. Advantageously, the provision of further additional cooling means such as ducts, valves and/or additional external systems, such as fans etc. for cooling an electrical vehicle component may be omitted.

A thermal coupling may generally be understood as a connection that may allow a thermal energy transfer from the connecting portion to the fluid flow channel. The connecting portion may accordingly include one or more materials suitable for thermally conducting heat, such as for instance metal materials or thermally conducting plastic materials.

In some examples, the thermal energy transfer may be a direct thermal energy or heat transfer from the electrical vehicle component to the contacted connection portion, further to the fluid flow channel and finally to the heat transporting fluid guided therethrough.

In one example, the support element has a first end and an oppositely arranged second end, and the support element is connectable to a vehicle body at the first end and/or at the second end.

Thus, the support element may be fixed at one or more distinct positions at a vehicle body of a vehicle and may accordingly provide a stable mounting of the electrical vehicle component attached to the support element.

The vehicle body may comprise one or more mechanically stable elements which may be interconnected, and which may form an essentially two- or three-dimensional support structure of the vehicle. In some examples, a vehicle body may include a passenger compartment of the vehicle and/or a chassis of the vehicle. A passenger compartment may be a substantially enclosed space in a vehicle that may be accessible to passengers and may be accordingly intended to accommodate passengers during operation of the vehicle. In some examples, the vehicle body may be arranged on top of the chassis of the vehicle.

According to the present disclosure, an arrangement at opposite ends may not be construed only to an arrangement at the opposite outermost extensions of the support element, but rather refers to portions of the support element that are located at different opposite positions along a certain direction. In some examples, the support element may be connected and secured to the vehicle body by one or more connecting features, such as screws, rivets, bolts etc. and/or may comprise protrusions or recesses which may engage respective corresponding protrusions or recesses of the vehicle body. The support element may be connected in a permanent manner or may be detachably mounted to the vehicle body. For instance, a first end may be a top end of the support element and an oppositely arranged second end may be a bottom end of the support element. Thus, the support element may be connected at the top and the bottom end or only at one of the two ends, for instance dependent on a configuration of the vehicle.

In one example, the support element comprises at least two plate-shaped body elements forming the plate-shaped body of the support element.

Thus, the support element may be formed by respective two or more body elements, which may facilitate one or more of a manufacturing, an assembly or a disassembly of the support element. Also, an exchange of one or more plate-shaped body elements, e.g. in case of damage or alteration, may be provided. Further, the plate-shaped body elements may be adapted to the electrical vehicle component to be supported.

Each body element may essentially extend in a plate-shaped manner. That is, it may substantially extend spatially in a main first direction and a main second direction, perpendicular to the first direction. Further, the body element may have only a minor extension in a third direction perpendicular to the first and second directions. For instance, the plate-shaped body element may extend essentially in a height direction of an associated vehicle, and a length direction of the associated vehicle, while having only a small thickness perpendicular to the height and length direction.

In some examples, two plate-shaped body elements may be provided, which may halve the plate-shaped body lengthwise. The two plate-shaped body elements may be accordingly fully or partially mirrored along a length direction. Thus, a main surface of one of the two plate-shaped body elements may face and contact a corresponding main surface of the other one of the plate-shaped body elements in an assembled condition.

In some examples, more than two plate-shaped body elements may be provided to form the plate-shaped body of the support element.

In some examples, the individual plate-shaped body elements may be made of or comprise the same material. In other examples, the individual plate-shaped body elements may be at least partially made of or comprise each different material. For instance, one plate-shaped body element may be made of a thermally insulating material, while another one of the plate-shaped body elements, which may accordingly comprise the connecting portion, may be made of a thermally conductive material. The plate-shaped body elements may be attached to each other to form the plate-shaped body of the support element in a fixed or detachably manner.

In one example, each plate-shaped body element defines at least one continuous recess, wherein the continuous recesses of the two plate-shaped body elements form the fluid flow channel.

Thus, a fluid flow channel may be manufactured at the plate-shaped body in a simplified manner. In some examples, one or more continuous recesses may be provided at a main surface of each plate-shaped body element in a fully or partially mirrored manner. Thus, when attaching the plate-shaped body elements to each other, the recesses may correspond to each other, thus forming a fluid flow channel. In some examples, the recesses may be formed in a way that the plate-shaped body provides sufficient mechanical stability to the support element, while at the same time, a proper heat transporting fluid flow inside the plate-shaped body may be ensured.

In some examples, only one plate-shaped body element may define at least one continuous recess and the other one of the two plate-shaped body elements may comprise a preferably flat recess-free surface. Thus, in an assembled condition, the flat surface of the one plate-shaped body element may cover the continuous recess of the other plate-shaped body to form a fluid flow channel.

In one example, the fluid flow channel is fluidly connectable to a cooling system of a vehicle battery.

Accordingly, the cooling system of the vehicle battery may be advantageously employed, and no additional cooling devices or pumps etc. needs to be provided to achieve proper cooling of the electrical vehicle component. This may accordingly further simplify a cooling of the electrical vehicle components.

In some examples, the support element may comprise fluid connections or interfaces at one end of the support element, for instance at the second end, which may be the bottom end of the support element if in an operational state. Thus, at a first fluid connection or interface, which may be an inflow interface of the fluid flow channel, an inflow of a cooled heat transporting fluid into the fluid flow channel may be provided. The fluid may then be guided through the fluid flow channel, and it may accordingly absorb heat transferred from the electrical vehicle component connected to the connection portion of the plate-shaped body. The thus heated fluid may then be discharged from the fluid flow channel at a second fluid connection or interface, which may be an outflow interface of the fluid flow channel. The discharged heated fluid may accordingly flow back to the cooling system of the vehicle battery, at which it may be allowed to release the transported heat and accordingly cool down again. The thus cooled heat transporting fluid may then be guided back again to the fluid flow channel. Altogether, the electrical vehicle element connected to the support element may be reliably cooled.

In one example, the support element has a thickness of 1 mm to 100 mm, preferably of 5 mm to 50 mm, more preferably of 10 mm to 30 mm and most preferred of about 20 mm.

Thus, a particular thin support element may be provided, which could be arranged in a very constrained space of a vehicle. At the same time, the support element may provide proper mounting and cooling capacities for electrical vehicle components. In some examples, when the support element is arranged along a length direction of an associated vehicle, which may substantially correspond to a standard forward drive direction of a vehicle, and a height direction oriented perpendicular to the length direction, the thickness of the support element may be an extension in the width direction oriented perpendicular to the length direction and the height direction.

In one example, the plate-shaped body comprises a main portion and an extension portion, wherein the extension portion is narrowed with respect to the main portion and wherein the connecting portion is provided on the main portion.

Thus, an increased contacting portion of the plate-shaped body for cooling an electrical vehicle element at the main portion may be provided. At the same time, the narrowed extension portion may be suitably adapted to be provided in a constrained space of a vehicle. The narrowed portion may extend less in one or more spatial directions with respect to the main portion of the plate-shaped body.

In some examples, the narrowed portion may extend less in a length direction of the support element compared to the main portion. The length direction of the support element may correspond to a length direction of an associated vehicle. For instance, the narrowed portion may exhibit only about up to two thirds of the length of the main portion, preferably only up to about half of the length of the main portion and most preferably only about up to one third of the length of the main portion. However, in other examples, the narrowed portion may also exhibit a different amount of narrowing or may relate to a height or width of the support element.

In some examples, the extension portion of the plate-shaped body may be used to create a connection of the support element with a vehicle body of the vehicle. In some examples, the main portion and the extension portion may be integrally formed or may be separately formed and connected with each other. In some examples, the narrowed portion may be provided at a first end of the support element. In some examples, the narrowed portion may extend in a height direction from the main portion.

In one example, the extension portion is free of the fluid flow channel.

Thus, a particular mechanically stable extension portion may be provided, which may be employed for instance to create a connection with a vehicle body of the vehicle. The extension portion may be for instance solidly formed and may comprise no recesses or channels. In some examples, an electrical vehicle component may be at least partially not arranged at the extension portion of the support element. In some examples, the electrical vehicle component may be connected only to the main portion of the plate shaped body. In some examples, only selective parts of the electrical vehicle components that do not require cooling may be connected to the extension portion.

According to a second aspect, there is provided a vehicle body for a vehicle comprising the support element according to the present disclosure, wherein the support element is provided inside the vehicle body and extends essentially along a height direction in an operational orientation of the vehicle.

The support element may be connected to the vehicle body at the first end and/or at the second end of the support element.

Thus, a vehicle body may be provided, which may advantageously offer an enlarged mounting and support space for electrical vehicle components, and at the same time may provide a proper cooling of the electrical vehicle components without the need of additional elements. Hence, an implementation of said electrical vehicle components in the vehicle may be facilitated and an easy access, e.g. for maintenance, and thus simplifying update, service and repair may be granted. The support element may provide a compact mounting support, which may be arranged in a very constraint space of a vehicle, for instance at least partially between neighboring front passenger seats or rear passenger seats and/or at least partially between the footwells of the front seats.

In some examples, the support element may be connected at one or more distinct positions of the vehicle body and may accordingly provide a stable mounting of an electrical vehicle component attached. The vehicle body may comprise one or more mechanically stable elements, which may be interconnected, and which may form an essentially two-dimensional or three-dimensional support structure or frame of the vehicle. In some examples, the vehicle body may include the passenger compartment of the vehicle. In some examples, the vehicle body may include a chassis of the vehicle. In some examples, the vehicle body may be arranged on top of the chassis of the vehicle.

As already noted above, an arrangement at opposite ends may not be construed only to an arrangement at the opposite outermost extensions of the support element, but rather refers to portions of the support element that are located at different opposite positions along a certain extension direction of the support element. In some examples, the support element may be connected and secured by one or more connecting features, such as welds, screws, rivets, bolts etc. and/or may comprise protrusions or recesses which may engage respective corresponding protrusions or recesses of the vehicle body. The support element may be connected in a permanent manner or may be detachably mounted to the vehicle body. In some examples, a first end may be a top end of the support element and an oppositely arranged second end may be a bottom end of the support element. In such a configuration, the support element may be connected at the top and the bottom end or only at one of the two ends with the vehicle body, e.g. dependent on the configuration of the vehicle.

Generally, the features and advantages explained above with respect to the support element likewise apply to the vehicle body of the present disclosure.

In one example, the vehicle body further comprises a passenger compartment extending along a length direction substantially corresponding to a standard forward drive direction of the vehicle, along a width direction oriented perpendicular to the length direction, and along the height direction oriented perpendicular to the length direction and the width direction, wherein the support element is arranged within the passenger compartment at a frontal position with respect to the length direction and at a central position with respect to the width direction.

Thus, a particular space-saving arrangement of the support element inside the vehicle may be achieved. In some examples, an arrangement of the support element at a frontal position may include an arrangement with respect to the length direction. In some examples the support element may be arranged within a frontal third of the passenger compartment with respect to the length direction, preferably within a frontal fourth of the passenger compartment with respect to the length direction, and more preferably within a frontal fifth of the passenger compartment with respect to the length direction.

In some examples, an arrangement of the support element at a central position with respect to the width direction may include an arrangement within a central third of the passenger compartment with respect to the width direction, preferably within a central fifth of the passenger compartment with respect to the width direction and most preferably within a central a central seventh of the passenger compartment with respect to the width direction.

In some examples, the support element may be provided at least partially between neighboring front passenger seats or rear passenger seats of the vehicle and/or at least partially between the footwells of the front seats.

In some examples, the above noted arrangement may also include one or more electrical vehicle components mounted to the support element.

In one example, the vehicle body further comprises a traverse component substantially extending along the width direction and arranged at a front side of the passenger compartment, and the first end of the support element is connected to the traverse component.

Accordingly, a stable mounting of the support element, and a corresponding secure attachment of an electrical component in the vehicle body may be achieved. Furthermore, the mounting position of the support element along the traverse component may be chosen as desired, for instance in a central position or rather left or right thereof along a width direction. This may enhance the flexibility of a suitable mounting position. In some examples, a traverse component may include a cross car beam. In some examples, a traverse component may include a vehicle instrument carrying element.

In some examples, the traverse component may be arranged in a front or frontal position of the passenger compartment of the vehicle. In some examples, the first end of the support element, which may be an upper end, may connected to the traverse component.

In one example, the vehicle body further comprises a floor component delimiting the passenger compartment, wherein the second end of the support element is connected to the floor component.

Thus, a proper mounting of the support element at one or more of the first and/or second ends may be achieved, which may increase a flexibility in the selection of suitable mounting positions for the support element in the vehicle. A floor component may include one or more elements that form a floor of a passenger compartment. In some examples, the floor component may essentially extend in a plane perpendicular to a height direction of the vehicle, i.e. essentially parallel to the ground upon which the vehicle operates. In some examples, the floor component may be mechanically rigid and stable such that one or more vehicle elements may be safely connected, thus preventing an undue movement of the support element during operation of the vehicle. Thus, the floor component may be particularly suitable for providing a stable fixation of the support element within the vehicle.

In some examples, the support element may be connected and secured with the floor component by one or more connecting features, such as welds, screws, rivets, bolts etc. and/or may comprise protrusions or recesses which may engage respective corresponding protrusions or recesses of the floor component. The support element may be connected in a permanent manner or may be detachably mounted to the floor component.

According to a third aspect, there is provided a vehicle comprising the support element according to the present disclosure or the vehicle body according to the present disclosure.

Thus, a vehicle may be provided, which may comprise an enlarged space for mounting and support of electrical vehicle components. At the same time, a proper cooling of the electrical vehicle component may be achieved without the need of additional cooling elements. Thus, a space for mounting e.g. a new and/or differently sized electrical vehicle component may be created in the vehicle. Furthermore, an easy access, e.g. for maintenance, update, service and repair of such components may be granted which may facilitate an implementation of said electrical vehicle components inside the vehicle. Accordingly, a larger number of electrical vehicle components and/or electrical vehicle components of an increased size may be provided in the vehicle. Furthermore, the provision of the electrical vehicle component at the support element may allow to relocate or omit structural elements of the vehicle, such as support beams or instrument panel elements, that have been previously used for mounting and/or cooling respective electrical vehicle components.

In some examples, the vehicle may be an electrically driven vehicle comprising a vehicle battery having a respective vehicle battery cooling system.

Generally, the features and advantages explained above with respect to the support element and the vehicle body likewise apply to the vehicle of the present disclosure.

According to a fourth aspect, there is provided a use of a support element for supporting an electrical vehicle component inside a vehicle, in particular inside a passenger compartment of the vehicle, wherein the support element comprises at least one fluid flow channel for guiding at least one heat transporting fluid.

Thus, an easy and robust way for cooling an electrical vehicle component in a vehicle may be provided. Additional cooling ducts, corresponding valves and further cooling elements, such as fans etc. may be accordingly omitted. This may simplify an overall arrangement and may allow providing additional electrical vehicle components or electrical vehicle components of an increased size in the vehicle. Further, vehicle components that may have an increased need for cooling may be suitably implemented in the vehicle. Further, simplified installation of the electrical vehicle components in the vehicle and an easier access to them may be achieved. Furthermore, the use according to the present disclosure may allow to reduce parts and/or an overall complexity of arrangements of elements in the vehicle. Further, a simple replacement of electrical vehicle components may be achieved, for instance if a computer unit mounted to and cooled by the support element needs to be upgraded.

Generally, the features and advantages explained above with respect to the support element, the vehicle body and the vehicle likewise apply to the use of the present disclosure.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: schematically shows different views of an example of a support element according to the present disclosure;
- Figure 2: schematically shows a view of an example of a support element according to the present disclosure; and
- Figure 3: schematically shows a view of an example of a vehicle according to the present disclosure.

### DETAILED DESCRIPTION

The figures are merely schematic representations and serve only to illustrate examples of the disclosure. Identical or equivalent elements are in principle provided with the same reference signs. Further, as used herein, a hyphenated form of a reference sign refers to a specific example of an element and the unhyphenated form of the reference numeral refers to the collective element. For example, a device "100-1" refers to an instance of a device class that can be collectively referred to as device " 100" and each of which can be generically referred to as device "100".

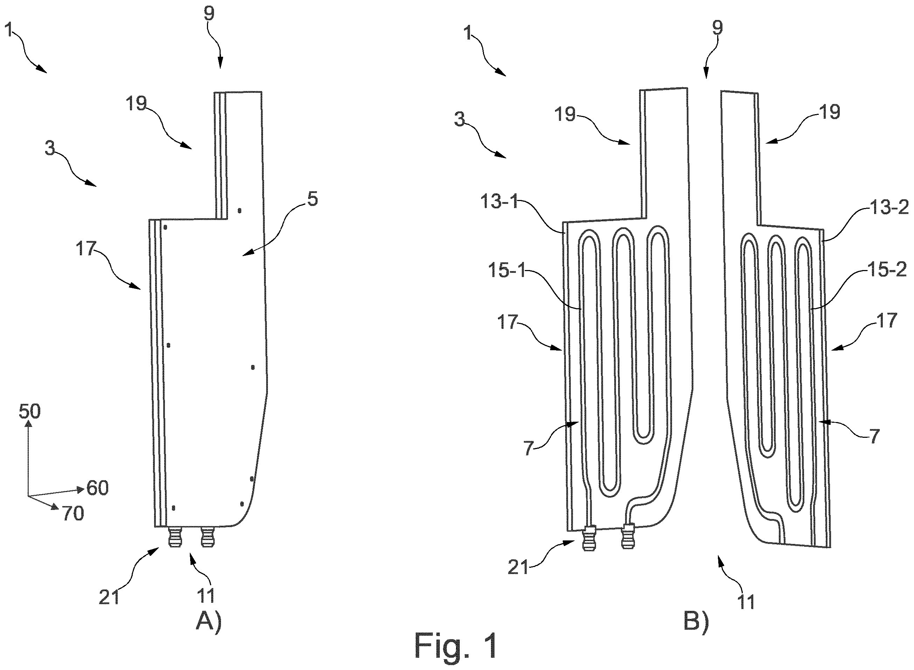

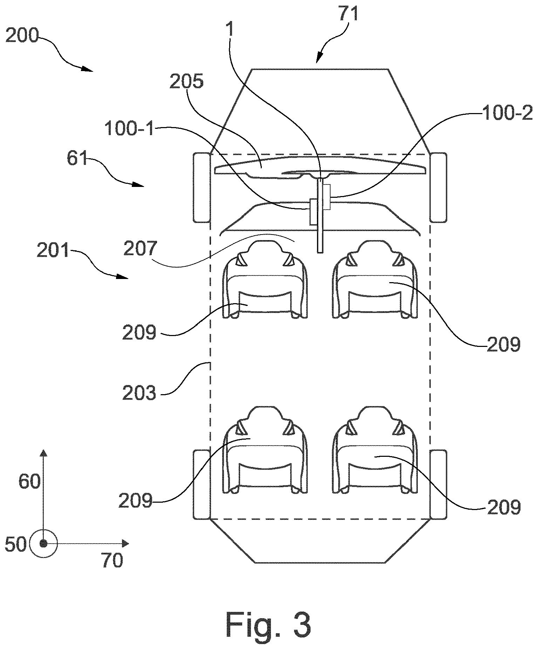

Figure 1 shows different views of an example of the support element 1 according to the present disclosure. In sub-figure 1A), the support element 1 is shown in an assembled condition and in sub-figure 1B) the support element 1 is shown in an unassembled condition. The support element 1 comprises a plate-shaped body 3 extending essentially along a height direction 50 in an operational orientation of a vehicle 200 (cf. Fig. 3). The support element 1 further extends along a length direction 60 perpendicular to the height direction 50 and has only a minor extension along a width direction 70 perpendicular to the height direction 50 and the length direction 60.

In the depicted example, the plate shaped body 3 extends for about 65 cm in the height direction 50, for about 28.5 cm in the length direction 60 and only about 2 cm in the width direction 70. Thus, a plate-shaped appearance is achieved. The plate-shaped body 3 comprises a connecting portion 5 for connecting an electrical vehicle component 100 to the support element 1 (cf. Fig. 3). In the depicted example, the connection portion 5 comprises a substantially two-dimensional flat outer surface of the support element 1. The support element 1 has a first end 9 and an oppositely arranged second end 11 so along the height direction 50. The support element 1 is connectable to a vehicle body 201 (cf. Fig. 3) at the first end 9 and/or at second end 11.

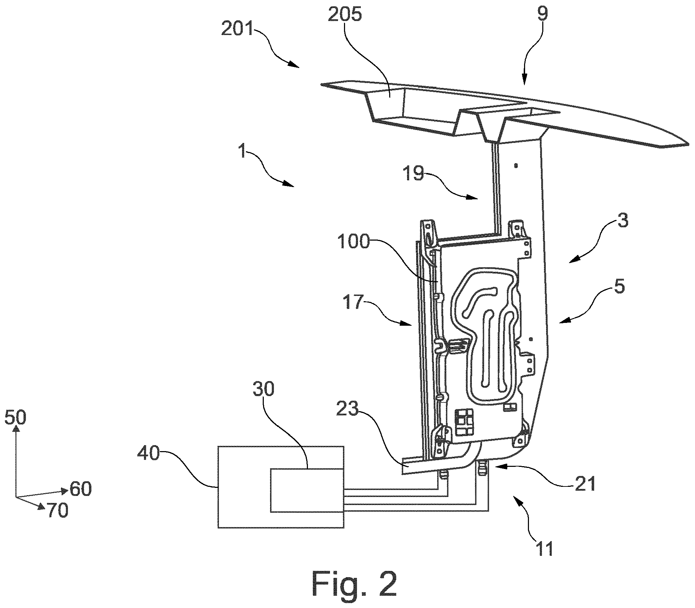

As is shown in sub-figure 1B), the support element 1 comprises a fluid flow channel 7 for guiding a heat transporting fluid. The fluid flow channel 7 is thermally coupled to the connecting portion 5. Thus, heat emitted from an electrical vehicle component 100 arranged on the election portion 5 is transferred to the fluid flow channel 7 and the heat transporting fluid located therein. Thus, the heat can be efficiently carried away from the electrical vehicle component 100. The fluid flow channel 7 is fluidly connectable to a cooling system 30 of a vehicle battery 40 (cf. Fig. 2). As is depicted, the support element 1 accordingly comprises respective fluid inlet and outlet connections 21 at its second end 11 to allow an inflow and outflow of each transporting fluid into and out of the fluid flow channel 7, respectively.

The plate-shaped body 3 comprises a main portion 17 and an extension portion 19, wherein the extension portion 19 is narrowed with respect to the main portion 17 in the length direction 60. Hence, the extension portion 19 arranged at a top portion of the support element 1 has a smaller length along the length direction 60 than the main portion 17. The connecting portion 5 is provided on the main portion 17. Further, as is shown in sub-figure 1B), the extension portion 19 is free of the fluid flow channel 7. In other words, the fluid flow channel 7 extends only in the main portion 17. The support element 1 comprises two plate-shaped body elements 13 forming the plate-shaped body 3 of the support element 1. Each plate-shaped body element 13 defines at least one continuous recess 15-1 and 15-2 corresponding to each other. Thus, the continuous recesses 15-1 and 15-2 of the two plate-shaped body elements 13 form the fluid flow channel 7 in an assembled condition of the support element 1.

Figure 2 shows another example of the support element 1 according to the present disclosure. In the present example, essentially the same elements as described above with respect to the example depicted in figure 1 are provided. In the depicted example, the support element 1 is connected at its first end 9, which is in the depicted example the upper end of the support element 1, to a traverse component 205 of a vehicle body 201. Further, an electrical vehicle component 100 is attached to the connection portion 5 of the plate shaped body 3 of the support element 1. In the depicted example, the electrical vehicle component 1 is a data processing and computing unit. At the second end 11 of the support element 1, the fluid connections 21 are connected to a cooling system 30 of a vehicle battery 40. Thus, an inflow and outflow of heat transporting fluid through the fluid flow channel 7 is achieved. Consequently, heat emitted from the electrical vehicle component 100 can be transferred via the connecting portion 5 to the fluid flow channel 7 and the heat transporting fluid arranged therein and can be transported away from the electrical vehicle component 100. Thus, the electrical vehicle component 100 can be efficiently cooled. The depicted example further comprises an electrical connection channel 23 arranged at the bottom side of the electrical vehicle component 100, through which means for electrical supply and/or data transmission, such as cables etc. may be guided.

Figure 3 schematically shows a view of an example of a vehicle 200 according to the present disclosure. In the depicted example, the vehicle 200 comprises a vehicle body 201 which includes a passenger compartment 203. As depicted, a traverse component 205 of the vehicle 200 extends substantially along the width direction 70. The traverse component 205 is arranged at a frontal position 61 of the passenger compartment 203. Further, the first end 9 of the support element 1 is connected to the traverse component 205. Also, the support element 1 is provided at a central position 71 of the passenger compartment 203. In the depicted example, the central position essentially corresponds to a position between the front passenger seats 209, in particular between the front footwells. Attached on both sides of the support element 1 are two electrical vehicle components 100-1 and 100-2, which may be accordingly cooled. The vehicle body 201 further comprises a floor component 207 delimiting the passenger compartment 203 towards a bottom side, i.e. in a direction towards the ground. The second end 11 of the support element 1 is connected to the floor component 207.

In all of the above-mentioned examples, the support element 1 is used for supporting the electrical vehicle component 100 inside the vehicle 200. More precisely, the support element 1 is used for supporting the electrical vehicle component 100 inside the passenger compartment 203 of the vehicle 200. Moreover, the support element 1 comprises at least one fluid flow channel 7 for guiding at least one heat transporting fluid such that the electrical vehicle component 100 may be effectively and efficiently cooled.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope of the claims.

### LIST OF REFERENCE SIGNS

- 1: support element
- 3: plate shaped body
- 5: connecting portion
- 7: fluid flow channel
- 9: first end of support element
- 11: second end of support element
- 13: plate shaped body element
- 15: continuous recess
- 17: main portion
- 19: extension portion
- 21: fluid connection
- 23: electrical connection channel
- 30: cooling system
- 40: vehicle battery
- 50: height direction
- 60: length direction
- 61: frontal position
- 70: width direction
- 71: central position
- 100: electrical vehicle component
- 200: vehicle
- 201: vehicle body
- 203: passenger compartment
- 205: traverse component
- 207: floor component
- 209: passenger seat
- 300: method

## Claims

1. A support element (1) for supporting an electrical vehicle component (100) inside a vehicle (200),
wherein the support element (1) comprises a plate-shaped body (3) extending essentially along a height direction (50) in an operational orientation of the vehicle (200),
wherein the plate-shaped body (3) comprises at least one connecting portion (5) for connecting at least one electrical vehicle component (100) to the support element (1), and
wherein the support element (1) comprises at least one fluid flow channel (7) for guiding at least one heat transporting fluid.

2. The support element (1) according to the preceding claim,
wherein the fluid flow channel (7) is thermally coupled to the connecting portion (5).

3. The support element (1) according to any one of the preceding claims,
wherein the support element (1) has a first end (9) and an oppositely arranged second end (11),
and wherein the support element (1) is connectable to a vehicle body (201) at the first end (9) and/or at the second end (11).

4. The support element (1) according to any one of the preceding claims,
wherein the support element (1) comprises at least two plate-shaped body elements (13) forming the plate-shaped body (3) of the support element (1).

5. The support element (1) according to the preceding claim,
wherein each plate-shaped body element (13) defines at least one continuous recess (15), and wherein the continuous recesses (15) of the two plate-shaped body elements (13) form the fluid flow channel (7).

6. The support element (1) according to any one of the preceding claims,
wherein the fluid flow channel (7) is fluidly connectable to a cooling system (30) of a vehicle battery (40).

7. The support element (1) according to any one of the preceding claims,
wherein the support element (1) has a thickness of 1 mm to 100 mm, preferably of 5 mm to 50 mm, more preferably of 10 mm to 30 mm and most preferred of about 20 mm.

8. The support element (1) according to any one of the preceding claims,
wherein the plate-shaped body (3) comprises a main portion (17) and an extension portion (19),
wherein the extension portion (19) is narrowed with respect to the main portion (17) and wherein the connecting portion (5) is provided on the main portion (17).

9. The support element (1) according to the preceding claim,
wherein the extension portion (19) is free of the fluid flow channel (7).

10. A vehicle body (201) for a vehicle (200) comprising the support element (1) according to one of the claims 1 to 9,
wherein the support element (1) is provided inside the vehicle body (201) and extends essentially along a height direction (50) in an operational orientation of the vehicle (200).

11. The vehicle body (201) according to the preceding claim, further comprising:
a passenger compartment (203) extending along a length direction (60) substantially corresponding to a standard forward drive direction of the vehicle (200), along a width direction (70) oriented perpendicular to the length direction (60), and along the height direction (50) oriented perpendicular to the length direction (60) and the width direction (70),
wherein the support element (1) is arranged within the passenger compartment (203) at a frontal position (61) with respect to the length direction (60) and at a central position (71) with respect to the width direction (70).

12. The vehicle body (201) according to the preceding claim,
wherein the vehicle body (201) further comprises a traverse component (205) substantially extending along the width direction (70) and arranged at a front side of the passenger compartment (203), and
wherein the first end (9) of the support element (1) is connected to the traverse component (205).

13. The vehicle body (201) according to any one of the preceding claims 11 or 12, further comprising a floor component (207) delimiting the passenger compartment (203), wherein the second end (11) of the support element (1) is connected to the floor component (207).

14. A vehicle (200) comprising the support element (1) according to any one of the claims 1 to 9 or the vehicle body (201) according to any one of the claims 10 to 13.

15. A use of a support element (1) for supporting an electrical vehicle component (100) inside a vehicle (200), in particular inside a passenger compartment (203) of the vehicle (200), wherein the support element (1) comprises at least one fluid flow channel (7) for guiding at least one heat transporting fluid.

## Amended claims

### Amended claims in accordance with Rule 137(2) EPC.

1. A vehicle body (201) for a vehicle (200) comprising a support element (1) for supporting an electrical vehicle component (100) inside the vehicle (200),
wherein the support element (1) comprises a plate-shaped body (3) extending essentially along a height direction (50) in an operational orientation of the vehicle (200),
wherein the plate-shaped body (3) comprises at least one connecting portion (5) for connecting at least one electrical vehicle component (100) to the support element (1),
wherein the support element (1) comprises at least one fluid flow channel (7) for guiding at least one heat transporting fluid, and
wherein the support element (1) is provided inside the vehicle body (201), **characterized in that** the vehicle body (201) further comprises:
a passenger compartment (203) extending along a length direction (60) substantially corresponding to a standard forward drive direction of the vehicle (200), along a width direction (70) oriented perpendicular to the length direction (60), and along the height direction (50) oriented perpendicular to the length direction (60) and the width direction (70),
wherein the support element (1) is arranged within the passenger compartment (203) at a frontal position (61) with respect to the length direction (60) and at a central position (71) with respect to the width direction (70).

2. The vehicle body (201) according to the preceding claim,
wherein the fluid flow channel (7) is thermally coupled to the connecting portion (5).

3. The vehicle body (201) according to any one of the preceding claims,
wherein the support element (1) has a first end (9) and an oppositely arranged second end (11),
and wherein the support element (1) is connectable to a vehicle body (201) at the first end (9) and/or at the second end (11).

4. The vehicle body (201) according to any one of the preceding claims,
wherein the support element (1) comprises at least two plate-shaped body elements (13) forming the plate-shaped body (3) of the support element (1).

5. The vehicle body (201) according to the preceding claim,
wherein each plate-shaped body element (13) defines at least one continuous recess (15), and wherein the continuous recesses (15) of the two plate-shaped body elements (13) form the fluid flow channel (7).

6. The vehicle body (201) according to any one of the preceding claims,
wherein the fluid flow channel (7) is fluidly connectable to a cooling system (30) of a vehicle battery (40).

7. The vehicle body (201) according to any one of the preceding claims,
wherein the support element (1) has a thickness of 1 mm to 100 mm, preferably of 5 mm to 50 mm, more preferably of 10 mm to 30 mm and most preferred of about 20 mm.

8. The vehicle body (201) according to any one of the preceding claims,
wherein the plate-shaped body (3) comprises a main portion (17) and an extension portion (19),
wherein the extension portion (19) is narrowed with respect to the main portion (17) and wherein the connecting portion (5) is provided on the main portion (17).

9. The vehicle body (201) according to the preceding claim,
wherein the extension portion (19) is free of the fluid flow channel (7).

10. The vehicle body (201) according to any one of the preceding claims,
wherein the vehicle body (201) further comprises a traverse component (205) substantially extending along the width direction (70) and arranged at a front side of the passenger compartment (203), and
wherein the first end (9) of the support element (1) is connected to the traverse component (205).

11. The vehicle body (201) according to any one of the preceding claims,
further comprising a floor component (207) delimiting the passenger compartment (203), wherein the second end (11) of the support element (1) is connected to the floor component (207).

12. A vehicle (200) comprising the vehicle body (201) according to any one of the preceding claims.

13. A use of a support element (1) for supporting an electrical vehicle component (100) inside a passenger compartment (203) of a vehicle body (201) of a vehicle (200),
wherein the support element (1) comprises at least one fluid flow channel (7) for guiding at least one heat transporting fluid,
wherein the support element (1) is provided inside the vehicle body (201) and extends essentially along a height direction (50) in an operational orientation of the vehicle (200),
wherein the passenger compartment (203) extends along a length direction (60) substantially corresponding to a standard forward drive direction of the vehicle (200), along a width direction (70) oriented perpendicular to the length direction (60), and along the height direction (50) oriented perpendicular to the length direction (60) and the width direction (70),
wherein the support element (1) is arranged within the passenger compartment (203) of the vehicle at a frontal position (61) with respect to a length direction (60) and at a central position (71) with respect to a width direction (70).
